# EUROPEAN PATENT APPLICATION

(11) **EP 2 568 512 A1**
(43) Date of publication of application: **13.03.2013**
(21) Application number: 11765351.9
(22) Date of filing: 17.03.2011
(51) Int. Cl.: H01L 33/32

(54) **NITROGEN COMPOUND SEMICONDUCTOR LIGHT EMITTING ELEMENT AND MANUFACTURING METHOD THEREOF**

(30) Priority: 09.04.2010 JP 2010090003
(71) Applicant: Ushio Denki Kabushiki Kaisha, Tokyo 100-8150 (JP)
(72) Inventor: TSUKIHARA, Masashi, Kyoto-shi Kyoto 600-8877 (JP); KAWASAKI, Koji, Kyoto-shi Kyoto 601-8034 (JP)
(74) Representative: Tomerius, Isabel
(86) International application number: PCT/JP2011/056388
(87) International publication number: WO 2011/125449

(57) **Abstract**

A nitrogen compound semiconductor light emitting element having an n-type layer, an active layer comprising AlGaInN and a p-type layer, emitting ultraviolet radiation with an emission peak wavelength of at most 400 nm and having a high emission intensity as well as a manufacturing method thereof are provided. In the nitrogen compound semiconductor light emitting element of the present invention having an n-type layer, an active layer and a p-type layer, the active layer consists of a nitrogen compound semiconductor layer with an emission peak wavelength of at most 400 nm comprising AlGaN, and the n-type layer has an n-type AIGaN layer comprising AIGaN and a GaN protective layer which does not contain Al and has a thickness of at least 5 nm. The active layer is formed on the protective layer. The manufacturing method comprises processes of growing the n-type AIGaN layer at a high substrate temperature of at least 1000 °C; growing the GaN protective layer of at most 400 nm not containing Al thereon; interrupting the growth process and decreasing the substrate temperature; and forming the active layer on the protective layer at a low substrate temperature of less than 1000 °C.

## Description

### Technical field

The present invention relates to a nitrogen compound semiconductor light emitting element emitting ultraviolet radiation with an emission peak wavelength of at most 400 nm and a manufacturing method thereof.

### Background art

As to light emitting elements (LED) comprising a nitrogen compound semiconductor and emitting ultraviolet radiation with an emission peak wavelength of at most 400 nm, so far e.g. those having the configuration shown in Fig. 6 are known (patent literature example 1).

This light emitting element is configured such that a buffer layer 82 comprising GaN is formed on a substrate 80, an n-type contact layer 84 with a large layer thickness is formed on the buffer layer 82, an n-type clad layer 86 is formed on the n-type contact layer 84, an active layer 88 comprising AlGaInN is formed on the n-type clad layer 86, and a p-type contact layer 92a with a large layer thickness and a p-type contact layer 92b with a small layer thickness are formed via a p-type clad layer 90 on the active layer 88. Further, an n-type electrode 94 is provided for which the surface of a portion of the n-type contact layer 84 is exposed, and a p-type electrode 96 is provided on the surface of the p-type contact layer 92b. The reference numeral 98 refers to a pad electrode.

Generally, regarding the layer making up the active layer in nitrogen compound semiconductor light emitting elements emitting ultraviolet radiation with an emission peak wavelength of at most 400 nm, it is necessary to form a layer wherein the composition ratio of In in AlGaInN is reduced, but it is widely known that, as the result of the performance of such a compositional modulation, the obtained light emitting element becomes an element with a reduced emission efficiency. That is, because the compositional modulation effect of In occurring when the composition ratio of In is high is mitigated by the reduction of the composition ratio of In, the confinement of electrons and positive holes becomes low and electrons and positive holes become easily trapped in dislocation because of which the probability of a rebonding without lighting increases.

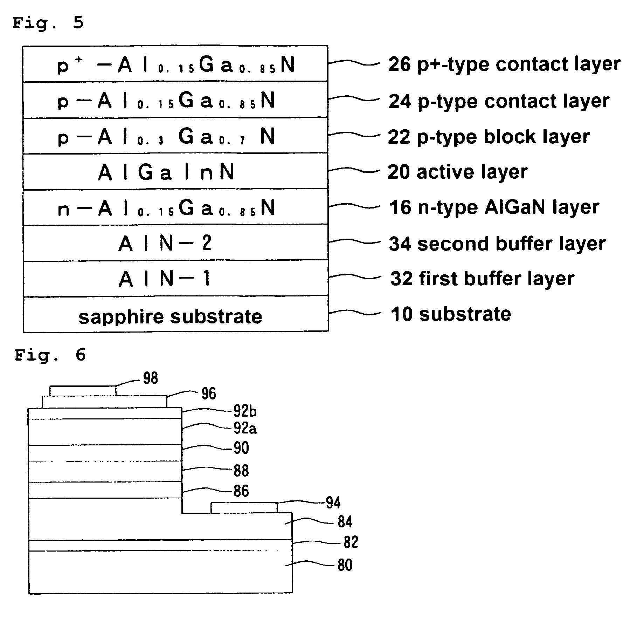

Further, when structural layers comprising GaN are formed in a light emitting element emitting ultraviolet radiation with a wavelength of at most 400 nm, a light absorption because of GaN and leaks of electrons and positive holes (a phenomenon wherein electrons or positive holes go beyond the light emitting layer and escape to the n-type layer and the p-type layer) occur. Therefore it is known to be advantageous to make up the crystal structure of the structural layers from AIGaN containing Al. For this reason the structural layers besides the buffer layer 82 and the active layer 88 being the light emitting layer in the light emitting element of Fig. 6, that is, the n-type contact layer 84, the n-type clad layer 86, the p-type clad layer 90 and the p-type contact layers 92a, 92b are all formed from AlGaN-based substances to reduce the self-absorption.

Then, nitrogen compound semiconductor light emitting elements of this kind are manufactured by growing the active layer and the other nitrogen compound semiconductor layers by organometal vapor phase growth. In the manufacture of the light emitting element of Fig. 6, the n-type AIGaN layer constituting the n-type clad layer 86 is grown and the AlGaInN layer constituting the quantum-well structure of the active layer 88 is grown directly thereon. But it is necessary to perform the growth of this n-type AIGaN layer under high temperature conditions wherein the substrate temperature reaches at least 1000 °C such as, for example, 1100 to 1200 °C while, on the other hand, it is necessary to perform the growth of the AlGaInN layer constituting the active layer under low temperature conditions of a substrate temperature of less than 1000 °C such as, for example, 750 to 900 °C.

In the manufacture of light emitting elements emitting light with an emission peak wavelength exceeding 400 nm, it is possible even in the case that the uppermost surface layer, which is contacted by the active layer, of the n-type layers being the lower layers is an AlGaN layer, to obtain a light emitting element having the same emission intensity characteristics as in the case of the uppermost surface layer of said n-type layers being a GaN layer. But in the manufacture of light emitting elements with an emission peak wavelength of at most 400 nm, it has been found that in the case that the uppermost surface layer, which is contacted by the active layer, of the n-type layers being the lower layers is an AIGaN layer the emission intensity decreases remarkably even if the crystal quality is the same.

That is, when a nitrogen compound semiconductor light emitting element emitting ultraviolet radiation with an emission peak wavelength of at most 400 nm is manufactured, it should be advantageous to use AIGaN as a substance for the other structural layers than the active layer because there is no absorption of the light emitted from the active layer, but when the uppermost surface layer, which is contacted by the active layer, of the n-type layers being the lower layers is an AIGaN layer, the emission intensity of the obtained light emitting element is in fact low.

The reason for the occurrence of this phenomenon is that, while the growth of the n-type layers is performed under high temperature conditions, the growth of the active layer must be performed under low temperature conditions and it is not possible to perform both growth processes continuously. This means that it is, in fact, practically inevitable to provide a growth process interruption period wherein the growth process is interrupted temporarily and the substrate temperature is reduced after the conclusion of the growth process of the n-type layers under high temperature conditions and before the start of the growth process of the active layer under low temperature conditions. It is believed that during this growth process interruption period, Ga in the AIGaN layer forming the uppermost surface of the n-type layers evaporates and scatters and crystal defects are generated because of the inconsistent crystal lattice and, as the result of passing on these crystal defects to the crystals of the AlGaInN of the active layer formed by growth thereon, crystal defects are generated inevitably in the formed active layer (non-patent literature example 1).

### Literature regarding the prior art

### Patent literature example

Patent literature example 1: JP 3614070 B2

### Non-patent literature example

Non-patent literature example 1: 54^{th} Spring Meeting of the Japan Society of Applied Physics, Collection of Lecture Manuscripts no. 1, 29p-ZN-4 'Influence of interruption of the growth when forming an AlGa-type hetero surface'

### Disclosure of the invention

### Problems to be solved by the invention

The present invention was made on the basis of the above circumstances and has the object to provide a nitrogen compound semiconductor light emitting element having an n-type layer, an active layer comprising AlGaInN and a p-type layer, emitting ultraviolet radiation with an emission peak wavelength of at most 400 nm and having a high emission intensity.

Another object of the present invention is to provide a method for the manufacture of a nitrogen compound semiconductor light emitting element by means of which a nitrogen compound semiconductor light emitting element having an n-type layer, an active layer comprising AlGaInN and a p-type layer and having a high emission intensity can be manufactured.

### Means for solving the problems

The nitrogen compound semiconductor light emitting element of the present invention having an n-type layer, an active layer and a p-type layer is characterized in that
said active layer comprises a nitrogen compound semiconductor layer having a peak emission wavelength of at most 400 nm and being provided with a barrier layer comprising AlₓGa_{y}In_{l-x-y}N (0 ≤ x ≤ 1, 0 ≤ y ≤ 1, 0 ≤ 1, x + y ≤ 1) and a well layer comprising AlₓGa_{y}In_{1-x-y}N (0 ≤ x < 1, 0 ≤ y < 1, x + y < 1);
said n-type layer has an n-type AIGaN layer comprising n-AlₓGa₁₋ₓN (0 < x ≤ 1) and a protective layer comprising GaN which does not contain Al and has a thickness of at least 5 nm and is formed on the n-type AlGaN-layer, and
said active layer is formed on the protective layer of said n-type layer.

The method for the manufacture of the nitrogen compound semiconductor light emitting element of the present invention wherein a nitrogen compound semiconductor light emitting element comprises an n-type layer, an active layer and a p-type layer each being formed by organometal vapor phase growth on a substrate is characterized by comprising
an n-type layer forming process wherein an n-type layer is formed under high temperature substrate conditions of a substrate temperature reaching at least 1000 °C by growing and forming an AIGaN layer comprising n-AlₓGa₁₋ₓN (0 < x ≤ 1) and growing and forming a protective layer comprising GaN which does not contain Al and has a thickness of at least 5 nm on said n-type AIGaN layer; and
an active layer forming process wherein afterwards the growth process is interrupted, the substrate temperature is reduced and an active layer is formed under low temperature conditions of the substrate temperature reaching less than 1000 °C by growing and forming a barrier layer comprising AlₓGa_{y}In_{1-x-y}N (0 ≤ x ≤ 1, 0 ≤ y ≤ 1, x + y ≤ 1) and a well layer comprising AlₓGa_{y}In_{1-x-y}N (0 ≤ x < 1, 0 ≤ y < 1, x + y < 1) on the protective layer of said n-type layer.

### Results of the invention

According to the present invention a growth process of an n-type layer containing an n-type AIGaN layer comprising n-type AIGaN is performed under high temperature conditions. After the conclusion thereof the growth process is interrupted temporarily, the substrate temperature is reduced and afterwards the growth process of the active layer under low temperature conditions is started. But because of the formation of the protective layer comprising GaN which does not contain Al and has a thickness of at least 5 nm on the n-type AIGaN layer comprising AIGaN, an evaporation and scattering of Ga in the n-type AIGaN layer being the lower layer during the period of the interruption of the growth process is prevented effectively and there are not crystal defects in said n-type AIGaN layer because of the evaporation and scattering of Ga. As a result, a good active layer without crystal defects can be formed by means of the growth of AlGaInN, and therefore, a nitrogen compound semiconductor light emitting element emitting ultraviolet radiation with an emission peak wavelength of at most 400 nm and having a high emission intensity can be obtained.

### Brief description of the drawings

Fig. 1 is an explanatory view showing the layer structure of the substrate and the semiconductor layers of an embodiment of the nitrogen compound semiconductor light emitting element of the present invention.
Fig. 2 is an explanatory view showing the layer structure of a light emitting element (comparison example 1) to be compared with the nitrogen compound semiconductor light emitting element of Fig. 1.
Fig. 3 is an explanatory view showing the layer structure of a light emitting element (control example 1) to be compared with the nitrogen compound semiconductor light emitting element of Fig. 1.
Fig. 4 is an explanatory view showing the layer structure of the substrate and the semiconductor layers of another embodiment of the nitrogen compound semiconductor light emitting element of the present invention.
Fig. 5 is an explanatory view showing the layer structure of a light emitting element (comparison example 2) to be compared with the nitrogen compound semiconductor light emitting element of Fig. 4.
Fig. 6 is an explanatory view showing the configuration of an example of a nitrogen compound semiconductor light emitting element of the state of the art.

### Modes for carrying out the invention

In the following, embodiments of the nitrogen compound semiconductor light emitting element of the present invention and the manufacturing method will be explained.

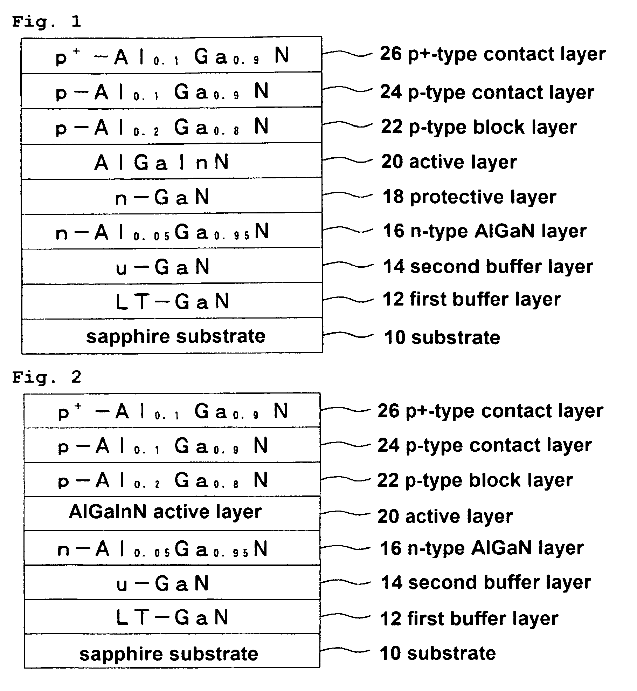

Fig. 1 is an explanatory view showing the layer structure of the substrate and the semiconductor layer of an embodiment of the nitrogen compound semiconductor light emitting element of the present invention.
This light emitting element has a first buffer layer 12 (LT-GaN) comprising a GaN layer with a layer thickness of, for example, 20 nm having been grown under low temperature conditions on the c-face of a sapphire substrate 10, and a second buffer layer 14 (u-GaN) comprising undoped GaN with a layer thickness of, for example, 1 µm having been grown under high temperature conditions on the first buffer layer 12. The functional region of the light emitting element is formed on the second buffer layer 14.

In the functional region on the second buffer layer 14, an n-type AIGaN layer 16 (n-AlGaN) comprising an n-type AlGaN layer with a layer thickness of, for example, 2.3 µm having been grown under high temperature conditions is formed; and a protective layer 18 (n-GaN) comprising GaN with a layer thickness of, for example, 50 nm having been grown under high temperature conditions is formed on the n-type AIGaN layer 16. By means of this, the n-type layer is formed.

An active layer 20 is formed by growing on the protective layer 18 comprising the n-type GaN layer. The active layer 20 of the example shown in the drawing has a quantum well structure for which a well layer comprising GaInN with a layer thickness of, for example, 2.5 nm and a barrier layer comprising AIGaN with a layer thickness of, for example, 10 nm each having been grown under low temperature conditions are stacked alternatingly in four periods.

A p-type block layer 22 with a layer thickness of, for example 20 nm, is formed on the active layer 20, and a p-type contact layer 24 with a layer thickness of, for example, 100 nm and a p⁺-type contact layer 26 with a layer thickness of, for example, 20 µm are formed on the p-type block layer 20.
Then, the light emitting element is made up by forming an n-electrode in a surface portion having been exposed e.g. by etching a part of the n-type AIGaN layer 16, and forming a p-electrode on the surface of the p⁺-contact layer 26.

As to the method for the manufacture of the nitrogen compound semiconductor light emitting element of the present invention, each layer of the nitrogen compound semiconductor is grown and formed by means of metal-organic chemical vapor deposition (MOCVD).
In the growth processes of each semiconductor layer, a vapor phase growth under conditions rendering a substrate temperature and a furnace internal pressure in accordance with the intended composition is performed.

In the organometal vapor phase growth, trimethyl aluminium (TMA) is used for the organometal compound becoming the source of supply for Al atoms, trimethyl gallium (TMG) is used for the organometal compound becoming the source of supply for Ga atoms, ammonia is used for the compound becoming the source of supply for N atoms, and nitrogen gas and hydrogen gas as used as the carrier gases, although there is no limitation to the above-mentioned substances.

Group-IV-atoms such as Si are used as the doping atoms for the formation of the n-type semiconductor layer, and tetraethyl silane (TESi) or the like can be used for the compound becoming the source of supply for the Si atoms. An AlₓGa_{y}In_{l-x-y}N (0 ≤ x ≤ 1, 0 ≤ y ≤ 1, x + y ≤ 1) semiconductor not doped with impurities exhibits the n-type also in an undoped state.
Group-II-atoms such as Mg are used as the doping atoms for the formation of the p-type semiconductor layer, and bis-cyclopentadienyl magnesium (Cp₂Mg) or the like can be used for the compound becoming the source of supply for the Mg atoms.

The active layer 20 is configured by growing and forming stack units wherein a barrier layer comprising AlₓGa_{y}In_{1-x-y}N (0 ≤ x ≤ 1, 0 ≤ y ≤ 1, x + y ≤ 1) and a well layer comprising AlₓGa_{y}In_{1-x-y}N (0 ≤ x < 1, 0 ≤ y < 1, x + y < 1) are positioned alternatingly for, e.g., 2 to 10 periods, and emits ultraviolet radiation with an emission peak wavelength of at most 400 nm. To enclose the electrons and the positive holes in the well layer, it is necessary to adjust the composition of the barrier layer such that the band gap energy thereof is rendered larger than that of the well layer. In preferred compositions of the well layer, the value for x is 0 to 0.99, and the value for y is 0 to 0.99. It is necessary that in the growth process of the active layer 20 the substrate temperature is adjusted to low temperature conditions of less than 1000 °C.

The n-type AlGaN layer 16 constituting an n-type layer is grown and formed on the buffer layers as a layer having the composition shown by n-AlₓGa₁₋ₓN (0 < x ≤ 1). To suppress an absorption of the emission wavelength, preferably this n-type AIGaN layer 16 is produced by a composition having a larger band gap energy than the emission wavelength. On this n-type AIGaN layer 16 a protective layer 18 from an n-type GaN layer which does not contain Al is grown and formed. The n-type layer having the protective layer 18 as the uppermost surface layer is formed by means of the n-type AIGaN layer 16 and the protective layer 18; and thereon the active layer 20 is formed.

In the present invention, the layer thickness of the protective layer is 5 nm to 100 nm. Preferably, the thickness of the protective layer is 10 to 80 nm. More preferably it amounts to 30 to 60 nm. If the layer thickness of the protective layer 18 is too small, it is not possible to cover the entire surface of the n-type AIGaN layer 16 sufficiently, and as the result of a portion thereof being exposed there is the risk that the composition of the uppermost surface layer by n-type AIGaN of said n-type AIGaN layer 16 cannot be protected effectively. If, in contrast, the layer thickness of the protective layer 18 is too large, the absorption of the emitted light by the protective layer 18 becomes large, and therefore it is difficult to obtain a light emitting element having a high emission intensity.

The substrate temperature in the growth processes of the structural layers comprising the semiconductor differs according to the composition of the semiconductor layer being formed. In the growth process of the active layer comprising AlGaInN, the substrate temperature is adjusted to low temperature conditions of less than 1000 °C and concretely, for example, 750 to 900 °C, as was mentioned above, while it is necessary for the n-type layer comprising AIGaN (concretely the n-type AIGaN layer 16 and the protective layer 18) and the p-type layer (concretely the p-type block layer 22, the p-type contact layer 24 and the p⁺-type contact layer 26) to adjust the substrate temperature to high temperature conditions of at least 1000 °C and concretely, for example, 1000 to 1200 °C.
As to the growth of the p-type layer, it is to be observed that In is contained in the active layer (light emitting layer), and if this growth is performed for a long time under high temperature conditions there may be a diffusion of In in the active layer and a decrease of the characteristics of the active layer. To suppress such a diffusion of In it is also possible to perform the growth at a temperature of less than 1000 °C.

In the method for the manufacture of the nitrogen compound semiconductor light emitting element of the present invention the n-type AlGaN layer 16 and the protective layer 18 are grown on the substrate 10 via a first buffer layer 12 and a second buffer layer 14 by means of which the n-type layer is formed. The active layer 20 is grown on this n-type layer and the p-type block layer 22, the p-type contact layer 24 and the p⁺-type contact layer 26 are grown on the active layer 20 by means of which the p-type layer is formed.

Concretely, the n-type AIGaN layer 16 comprising AIGaN is grown and formed under high temperature conditions of the substrate temperature reaching at least 1000 °C, and afterwards the protective layer 18 comprising GaN which does not contain Al is grown and formed to a specified layer thickness of 5 to 100 nm under the same high temperature conditions. After the conclusion of the growth and formation of the protective layer 18, the growth process is interrupted temporarily and the substrate temperature is reduced. Then, the growth and formation of the active layer 20 on the n-type layer the uppermost surface layer thereof being formed by the protective layer 18 is performed under low temperature conditions of a substrate temperature of less than 1000°C.

To reduce the substrate temperature in the transition from the growth process under high temperature conditions to the growth process under low temperature conditions, it is inevitable to provide for a growth process interruption period which may also be referred to as a heat radiation period. Although the length of this growth process interruption period differs according to the temperature of the substrate under the high temperature conditions and the temperature of the substrate under the low temperature conditions, it usually amounts to 5 to 10 minutes.

As was mentioned above, in the actual manufacture of a nitrogen compound semiconductor light emitting element the substrate temperature is reduced during a growth process interruption period after the growth and formation of the n-type layer under high temperature conditions, and then the growth and formation of the active layer 20 is performed under low temperature conditions. But according to the present invention the protective layer 18 comprising GaN which does not contain Al is formed on the n-type AlGaN layer 16 comprising AIGaN and constituting the n-type layer. As the composition of this protective layer 18 does not change during the growth process interruption period, there is no generation of crystal defects. Therefore, a generation of crystal defects in the active layer 20 being grown and formed on the protective layer 18, which is caused by crystal defects in the lower layer, is suppressed and, as a result, a nitrogen compound semiconductor light emitting element having a high emission intensity can be obtained.

### Embodiments

### Embodiment 1

In this embodiment, each semiconductor layer was grown and formed by means of the organometal vapor phase growth described below following the layer configuration of Fig. 1, and a light emitting element of the present invention was obtained.

### (1) Substrate cleaning process

First, a c-face sapphire substrate 10 was arranged in the processing furnace of a CVD device and a cleaning of the substrate 10 was performed by increasing the substrate temperature to 1150 °C while hydrogen gas was supplied into the processing furnace with a flow rate of 10 slm.

### (2) Process of forming the first buffer layer

Then, a GaN layer with a layer thickness of 20 nm was grown on the surface of the substrate 10 and the first buffer layer (LT-GaN) 12 was formed under conditions of a furnace internal pressure of 100 kPa and a substrate temperature of 500 °C by supplying ammonia with a flow rate of 250000 µmol/min and trimethyl gallium (TMG) with a flow rate of 50 µmol/min for 70 seconds while nitrogen gas with a flow rate of 5 slm and hydrogen gas with a flow rate of 5 slm were supplied into the furnace as carrier gases.

### (3) Process of forming the second buffer layer

An undoped GaN layer with a layer thickness of 1.5 µm was grown on the first buffer layer 12 and the second buffer layer (u-GaN) 14 was formed under the condition of a substrate temperature of 1125 °C by supplying ammonia with a flow rate of 250000 µmol/min and TMG with a flow rate of 100 µmol/min for 30 minutes while nitrogen gas with a flow rate of 20 slm and hydrogen gas with a flow rate of 15 slm were supplied into the furnace as carrier gases.

### (4) Process of forming the n-type layer

### (4-1) Process of forming the n-type AIGaN layer

The n-type AIGaN layer 16 comprising an n-type Al_{0.05}Ga_{0.95}N layer with a layer thickness of 2.3 µm was formed under conditions of a substrate temperature of 1150 °C and a furnace internal pressure of 30 kPa by supplying trimethyl aluminium (TMA) with a flow rate of 5.2 µmol/min and TESi with a flow rate of 0.013 µmol/min while nitrogen gas with a flow rate of 20 slm and hydrogen gas with a flow rate of 15 slm were supplied into the furnace as carrier gases such as in the above-mentioned growth process of the second buffer layer (3).

### (4-2) Process of forming the protective layer

Then, the protective layer (n-GaN) 18 not containing Al with a layer thickness of 50 nm was grown on the n-type AIGaN layer 16 by means of continuing the growth process for 55 seconds under the same conditions with the exception of stopping the TMA supply, by means of which the n-type layer was formed.

### (5) Process of forming the active layer

The growth process was interrupted after the above-mentioned process of forming the protective layer (4-2), and afterwards a process of forming a well layer having a composition of Ga_{0.95}In_{0.05}N with a layer thickness of 2.5 nm by supplying TMG with a flow rate of 10 µmol/min and trimethyl indium (TMI) with a flow rate of 12 µmol/min for 60 seconds and a process of forming a barrier layer having a composition of Al_{0.08}Ga_{0.92}N with a layer thickness of 10 nm by supplying TMG with a flow rate of 10 µmol/min and TMA with a flow rate of 0.9 µmol/min for 300 seconds were performed repeatedly under the conditions of a furnace internal pressure of 100 kPa and a substrate temperature of 820 °C while nitrogen gas with a flow rate of 15 slm and hydrogen gas with a flow rate of 1 slm were supplied into the furnace as carrier gases. Thus, the active layer 20 comprising a stack of 4 periods of units of the well layer and the barrier layer was formed.
The growth process interruption time from the moment of the conclusion of the process of forming the protective layer (4-2) to the start of the process of forming the active layer was approximately 8 minutes.

### (6) Process of forming the p-type layer

### (6-1) Process of forming the p-type block layer

Then, the substrate temperature was adjusted to 1025 °C and a layer of p-type Al_{0.2}Ga_{0.8}N with a layer thickness of 20 nm was grown on the active layer 20 by supplying TMG with a flow rate of 100 µmol/min, TMA with a flow rate of 24 µmol/min and bis-cyclopentadienyl magnesium (Cp₂Mg) with a flow rate of 0.1 µmol/min for 20 seconds while nitrogen gas with a flow rate of 15 slm and hydrogen gas with a flow rate of 25 slm were supplied as carrier gases into the processing furnace at a furnace internal pressure of 100 kPa, by means of which the p-type block layer 22 was formed.

### (6-2) Process of forming the p-type contact layer

Subsequently, the p-type contact layer 24 comprising p-type Al₀.₁₀Ga₀.₉₀N with a layer thickness of 100 nm was formed on the p-type block layer 24 by continuing the growth process for 100 seconds with the exception of changing the flow rate of TMA to 12 µmol/min.

### (6-3) Process of forming the p⁺-type contact layer

Then, the p⁺-type contact layer 26 comprising p⁺-type Al_{0.1}Ga_{0.9}N with a layer thickness of 20 nm was formed on the p-type contact layer 24 by continuing the growth process for 20 seconds with the exception of changing the flow rate of Cp₂Mg to 0.2 µmol/min.

### (7) Post processing processes

### (7-1) Activation annealing process

After the conclusion of the above-mentioned process (6), an activation annealing was performed in the atmosphere at a temperature of 700 °C for 15 minutes.

### (7-2) Process of forming the electrodes

A pad part was formed by etching and exposing a portion of the n-type AIGaN layer 16 of the n-type layer of the light emitting element material having been subjected to the activation annealing process by means of photolithography and an inductively coupled plasma processing device (ICP). After 5 nm nickel and 5 nm gold had been layered on both of this n-pad part and a p-pad part having been provided at the surface of the p⁺-type contact layer 26, an annealing was performed in the atmosphere at a temperature of 500 °C for 5 minutes, Al was vapor deposited on both of the n-pad part and the p-pad part and an n-electrode and a p-electrode were formed. Thus, a light emitting element with an emission peak wavelength in the 370 nm band was produced. This element is referred to as 'light emitting element 1'.

### Comparison example 1

A light emitting element for comparison with an emission peak wavelength in the 370 nm band having the layer configuration shown in Fig. 2 was manufactured by growing and forming each semiconductor layer in the same way as in embodiment 1 with the exception of not performing the process of forming the protective layer (4-2) after the conclusion of the process of forming the n-type AlGaN layer (4-1) and carrying out the process of forming the active layer (5) after a growth process interruption period of approximately 8 minutes such as in the above-mentioned embodiment 1. This element is referred to as 'light emitting element 1a'.

### Contrast example 1

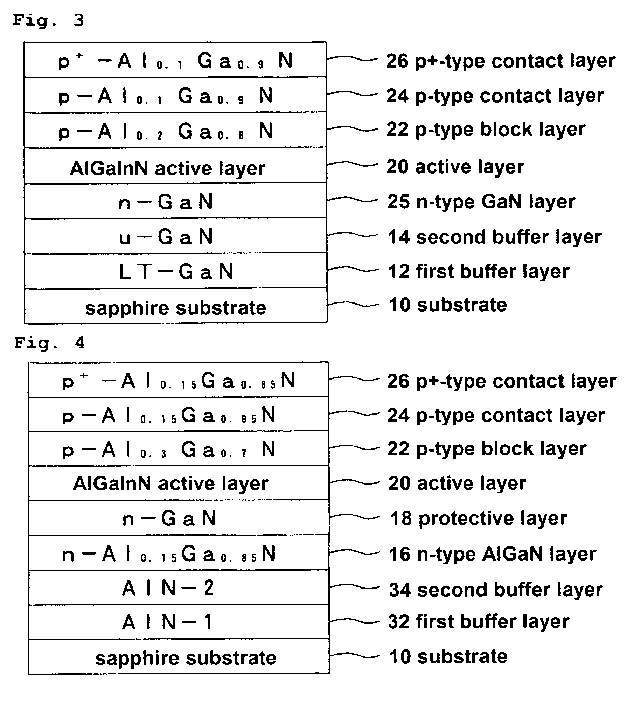

A light emitting element for comparison with an emission peak wavelength in the 370 nm band having the layer configuration shown in Fig. 3 was manufactured by growing and forming each semiconductor layer in the same way as in embodiment 1 with the exception of forming - subsequent to the process of forming the second buffer layer (3) and without performing the process of forming the n-type AlGaN layer (4-1) and the process of forming the protective layer (4-2) - an n-type GaN layer 28 by growing n-type GaN with a layer thickness of 2.3 µm on the second buffer layer 14 under the same condition of a substrate temperature of 1125 °C as in the process of forming the second buffer layer (3) by means of supplying ammonia with a flow rate of 250000 µmol/min, TMG with a flow rate of 100 µmol/min and tetramethyl silane (TESi) with a flow rate of 0.013 µmol/min for 40 minutes while nitrogen gas with a flow rate of 20 slm and hydrogen gas with a flow rate of 15 slm were supplied into the furnace as carrier gases, and carrying out the process of forming the active layer (5) after a growth process interruption period of approximately 8 minutes such as in the above-mentioned embodiment 1. This element is referred to as 'light emitting element 1b'.

### Evaluation test (1)

An evaluation of the output was performed for each of the light emitting element 1 according to the above-mentioned embodiment 1, the light emitting element 1a according to comparison example 1 and the light emitting element 1b according to contrast example 1. That means, each light emitting element was mounted in a TO-18 stem package, a photo diode having a sensitivity in the band of 360 to 370 nm and having been subjected to a sensitivity amendment was arranged opposingly at a position being 5 mm apart as a light receiving element, and the output value of the light receiving element when supplying a current of 20 mA to each light emitting element was measured. The results are as shown in table 1.

**Table 1**

| | Light emitting element | Output value of light receiving element |
|---|---|---|
| Embodiment 1 | Light emitting element 1 | 1.15 mW |
| Comparison example 1 | Light emitting element 1a | 0.12 mW |
| Contrast example 1 | Light emitting element 1b | 1.00 mW |

It is understood from the results in table 1 that because of the formation of the protective layer a very large emission intensity can be obtained from the light emitting element 1 according to embodiment 1 as compared to the light emitting element 1a according to comparison example 1.

### Embodiment 2

In this embodiment, each semiconductor layer was grown and formed by means of the organometal vapor phase growth described below following the layer configuration of Fig. 4, and a light emitting element of the present invention was obtained.

### (1) Substrate cleaning process

First, a c-face sapphire substrate 10 was arranged in the processing furnace of a CVD device and a cleaning of the substrate 10 was performed by increasing the substrate temperature to 1150 °C while hydrogen gas was supplied into the processing furnace with a flow rate of 10 slm.

### (2) Process of forming the first buffer layer

Then, an AIN layer with a layer thickness of 50 nm was grown on the surface of the substrate 10 and the first buffer layer (AlN-1) 32 was formed under conditions of a furnace internal pressure of 10 kPa and a substrate temperature of 950 °C by supplying ammonia with a flow rate of 13920 µmol/min and TMA with a flow rate of 8.70 µmol/min for 700 seconds while nitrogen gas with a flow rate of 8 slm and hydrogen gas with a flow rate of 8 slm were supplied into the furnace as carrier gases.

### (3) Process of forming the second buffer layer

After the conclusion of the above-mentioned process of forming the first buffer layer (2) the supply of TMA was stopped and the substrate temperature was raised to 1300 °C and an AIN layer with a layer thickness of 1 µm was grown on the first buffer layer 32 and the second buffer layer (AlN-2) 34 was formed by supplying ammonia with a flow rate of 22000 µmol/min and TMA with a flow rate of 50 µmol/min for 80 minutes into the furnace.

### (4) Process of forming the n-type layer

### (4-1) Process of forming the n-type AIGaN layer

After the conclusion of the process of forming the second buffer layer (3) the furnace internal pressure was adjusted to 30 kPa and the n-type AlGaN layer 16 comprising an n-type Al_{0.15}Ga_{0.85}N layer with a layer thickness of 3 µm was formed under the conditions of a substrate temperature of 1165 °C by supplying TMG with a flow rate of 100 µmol/min, TMA with a flow rate of 18 µmol/min, ammonia with a flow rate of 250000 µmol/min and TESi with a flow rate of 0.013 µmol/min for 50 minutes while nitrogen gas with a flow rate of 15 slm and hydrogen gas with a flow rate of 12 slm were supplied into the furnace as carrier gases.

### (4-2) Process of forming the protective layer

Then, the protective layer (n-GaN) 18 not containing Al with a layer thickness of 50 nm was grown on the n-type AIGaN layer 16 by means of continuing the growth process for 55 seconds under the same conditions with the exception of stopping the TMA supply, by means of which the n-type layer was formed.

### (5) Process of forming the active layer

A process of forming a well layer having a composition of Al_{0.02}Ga_{0.95}In₀₋₀₃N with a layer thickness of 2 nm by supplying TMG with a flow rate of 10 µmol/min, TMA with a flow rate of 0.02 µmol/min and TMI with a flow rate of 35 µmol/min for 50 seconds and a process of forming a barrier layer having a composition of Al_{0.14}Ga_{0.86}N with a layer thickness of 10 nm by supplying TMG with a flow rate of 10 µmol/min and TMA with a flow rate of 1.5 µmol/min for 300 seconds were performed repeatedly under the conditions of a furnace internal pressure of 100 kPa and a substrate temperature of 840 °C while nitrogen gas with a flow rate of 16 slm was supplied into the furnace as carrier gas. Thus, the active layer 20 comprising a stack of 4 periods of units of the well layer and the barrier layer was formed.
The growth process interruption time from the moment of the conclusion of the process of forming the n-type layer (4) to the start of the process of forming the active layer was approximately 7 minutes.

### (6) Process of forming the p-type layer

### (6-1) Process of forming the p-type block layer

Then, the substrate temperature was adjusted to 1050 °C and a layer of p-type Al_{0.3}Ga_{0.7}N with a layer thickness of 20 nm was grown on the active layer 20 by supplying TMG with a flow rate of 100 µmol/min, TMA with a flow rate of 36 µmol/min and Cp₂Mg with a flow rate of 0.26 µmol/min for 20 seconds while nitrogen gas with a flow rate of 15 slm and hydrogen gas with a flow rate of 25 slm were supplied as carrier gases into the processing furnace at a furnace internal pressure of 100 kPa, by means of which the p-type block layer 22 was formed.

### (6-2) Process of forming the p-type contact layer

Subsequently, the p-type contact layer 24 comprising p-type Al_{0.15}Ga_{0.85}N with a layer thickness of 100 nm was formed on the p-type block layer 24 by continuing the growth process for 100 seconds with the exception of changing the flow rate of TMA to 18 µmol/min.

### (6-3) Process of forming the p⁺-type contact layer

Then, the p⁺-type contact layer 26 comprising p⁺-type Al_{0.15}Ga_{0.85}N with a layer thickness of 20 nm was formed on the p-type contact layer 24 by continuing the growth process for 20 seconds with the exception of changing the flow rate of Cp₂Mg to 0.2 µmol/min.

### (7) Post processing processes

### (7-1) Activation annealing process

After the conclusion of the above-mentioned process (6), an activation annealing was performed in the atmosphere at a temperature of 700 °C for 15 minutes.

### (7-2) Process of forming the electrodes

A pad part was formed by etching and exposing a portion of the n-type AIGaN layer 16 of the n-type layer of the light emitting element material having been subjected to the activation annealing process by means of photolithography and an inductively coupled plasma processing device (ICP). After 5 nm nickel and 5 nm gold had been layered on both of this n-pad part and a p-pad part having been provided at the surface of the p⁺-type contact layer 26, an annealing was performed in the atmosphere at a temperature of 500 °C for 5 minutes, Al was vapor deposited on both of the n-pad part and the p-pad part and an n-electrode and a p-electrode were formed. Thus, a light emitting element with an emission peak wavelength in the 360 nm band was produced. This element is referred to as 'light emitting element 2'.

### Comparison example 2

A light emitting element for comparison having the layer configuration shown in Fig. 5 was manufactured by growing and forming each semiconductor layer in the same way as in embodiment 2 with the exception of not performing the process of forming the protective layer (4-2) after the conclusion of the process of forming the n-type AIGaN layer (4-1) and carrying out the process of forming the active layer (5) after a growth process interruption period of approximately 7 minutes such as in the above-mentioned embodiment 2. This element is referred to as 'light emitting element 2a'.

### Evaluation test (2)

An evaluation of the output was performed in the same way as in the evaluation test (1) for each of the light emitting element 2 according to the above-mentioned embodiment 2 and the light emitting element 2a according to comparison example 2. Then, the output value of the light receiving element with regard to the wavelength of 360 nm when supplying a current of 20 mA to each light emitting element was measured. The results are as shown in table 2.

**Table 2**

| | Light emitting element | Output value of light receiving element |
|---|---|---|
| Embodiment 2 | Light emitting element 2 | 0.50 mW |
| Comparison example 2 | Light emitting element 2a | 0.05 mW |

It is understood from the results in table 2 that because of the formation of the protective layer a very large emission intensity can be obtained from the light emitting element 2 according to embodiment 2 as compared to the light emitting element 2a according to comparison example 2.

### Explanation of reference numerals

- 10: c-face sapphire substrate
- 12: first buffer layer (LT-GaN)
- 14: second buffer layer (u-GaN)
- 16: n-type AIGaN layer
- 18: protective layer (n-GaN)
- 20: active layer
- 22: p-type block layer
- 24: p-type contact layer
- 26: p⁺-type contact layer
- 28: n-type GaN layer
- 32: first buffer layer (AlN-1)
- 34: second buffer layer (AlN-2)
- 80: substrate
- 82: buffer layer
- 84: n-type contact layer
- 86: n-type clad layer
- 88: active layer
- 90: p-type clad layer
- 92a: p-type contact layer
- 92b: p-type contact layer
- 94: n-electrode
- 96: p-electrode
- 98: pad electrode

## Claims

1. A nitrogen compound semiconductor light emitting element having an n-type layer, an active layer and a p-type layer, **characterized in that** said active layer comprises a nitrogen compound semiconductor layer having a peak emission wavelength of at most 400 nm and being provided with a barrier layer comprising AlₓGa_{y}In_{1-x-y}N (0 ≤ x ≤ 1, 0 ≤ y ≤ 1, x + y ≤ 1) and a well layer comprising AlₓGa_{y}In_{1-x-y}N (0 ≤ x < 1, 0 ≤ y < 1, x + y < 1);
said n-type layer has an n-type AlGaN layer comprising n-AlₓGa₁₋ₓN (0 < x ≤ 1) and a protective layer comprising GaN which does not contain Al and has a thickness of at least 5 nm and is formed on the n-type AIGaN layer, and
said active layer is formed on the protective layer of said n-type layer.

2. A method for the manufacture of a nitrogen compound semiconductor light emitting element wherein a nitrogen compound semiconductor light emitting element comprises an n-type layer, an active layer and a p-type layer each being formed by organometal vapor phase growth on a substrate, **characterized by** comprising
an n-type layer forming process wherein an n-type layer is formed under high temperature conditions of a substrate temperature reaching at least 1000 °C by growing and forming an AIGaN layer comprising n-AlₓGa₁₋ₓN (0 < x ≤ 1) and growing and forming a protective layer comprising GaN which does not contain Al and has a thickness of at least 5 nm on said n-type AIGaN layer; and
an active layer forming process wherein afterwards the growth process is interrupted, the substrate temperature is reduced and an active layer is formed under low temperature conditions of the substrate temperature reaching less than 1000 °C by growing and forming a barrier layer comprising AlₓGa_{y}In_{1-x-y}N (0≤ x ≤ 1, 0 ≤ y ≤ 1, x + y ≤ 1) and a well layer comprising AlₓGa_{y}In_{1-x-y}N (0 ≤ x < 1, 0 ≤ y < 1, x + y < 1) on the protective layer of said n-type layer.
